# EUROPEAN PATENT APPLICATION

(11) **EP 4 645 616 A1**
(43) Date of publication of application: **05.11.2025**
(21) Application number: 24766451.9
(22) Date of filing: 06.03.2024
(51) Int. Cl.: H02B 1/56, G01R 19/145, H02B 1/32, H02B 1/30, H02B 1/28

(54) **HIGH-VOLTAGE FREQUENCY CONVERSION BYPASS CABINET HAVING ELECTRIFIED DISPLAY FUNCTION AND WORKING METHOD THEREOF**

(30) Priority: 07.03.2023 CN 202310208406
(71) Applicant: Aksa Power Generation (China) Co., Ltd., Changzhou, Jiangsu 213000 (CN)
(72) Inventor: OZBELLI, Yahya, Hangzhou, Jiangsu 213000 (CN)
(74) Representative: Sun, Yiming
(86) International application number: PCT/CN2024/080210
(87) International publication number: WO 2024/183736

(57) **Abstract**

The present invention relates to a high-voltage variable-frequency bypass cabinet having a charged display function, including: a bypass cabinet body, a cabinet door, a charged display instrument, an air inlet opening provided at one end of the charged display instrument, an air outlet opening provided at the other end of the charged display instrument, an abutment portion arranged at an open end of the air outlet opening, and an adjustment portion arranged on a side away from the open end of the air outlet opening. After use of the charged display instrument according to the present invention ends, the adjustment portion retracts to scrape dust on an inner wall of the air outlet opening. Moreover, during use of the charged display instrument, a temperature inside the charged display instrument continuously rises, and the adjustment portion can block the air outlet opening, to enable the charged display instrument to quickly reach an appropriate working temperature. In addition, when the temperature inside the charged display instrument is excessively high, the adjustment portion is driven, to implement a heat dissipation effect. Moreover, in a process of continuing driving the adjustment portion, the adjustment portion is inclined, and discharged hot air can quickly pass through an interior of the adjustment portion, and dust inside the adjustment portion can be quickly discharged.

## Description

### TECHNICAL FIELD

The present invention relates to the field of bypass cabinet technologies, and specifically, to a high-voltage variable-frequency bypass cabinet having a charged display function and a working method thereof.

### BACKGROUND

At present, high-voltage variable-frequency devices have been widely applied, and are used throughout industries such as power generation, metallurgy, petrochemical, and mining. A high-voltage variable-frequency bypass cabinet is an important device in the high-voltage variable-frequency devices, is mainly configured to provide an inverter power supply and a load power supply, and mainly implements functions such as switch on-off, control, or protection. Various high-voltage switches and contactors are mounted inside the high-voltage variable-frequency bypass cabinet. To protect the device and personal safety, when switch-off and switch-on operations are performed, the switch-off and switch-on operations need to be performed in accordance with specified operating procedures. However, during actual operation, it is easy to make mistakes in switch-off and switch-on procedures, resulting in serious consequences of device damage and casualties. For such a case, a charged display apparatus detecting a running status of a primary circuit is mounted on the bypass cabinet. The apparatus includes two units, a high-voltage sensor and a charged display, that are connected as one by a wire. The apparatus can not only indicate whether a high-voltage circuit is charged, but also cooperate with an electromagnetic lock to achieve forced locking, to prevent a charged chamber from being mistakenly entered, thereby reducing accidents caused by an operator opening, by mistake, a door of the charged chamber without knowing whether the bypass cabinet is energized.

However, in actual use of the charged display, an instrument determines a use environment according to an installation position of the bypass cabinet, and the instrument is charged for use and is convenient to replace, install, and move without being connected to a specific power supply line. However, because there is a battery inside the body of the instrument, if the battery is used in a low-temperature or high-temperature environment, a battery life and a service life of the battery are affected. In addition, when the battery is used frequently, there is a risk of blockage in an internal heat dissipation channel of the battery, which degrades a heat dissipation effect of the instrument. Therefore, a novel high-voltage variable-frequency bypass cabinet having a charged display function is needed for replacement.

### SUMMARY OF THE INVENTION

An objective of the present invention is to provide a high-voltage variable-frequency bypass cabinet having a charged display function and a working method thereof.

To resolve the foregoing problems, the present invention provides a high-voltage variable-frequency bypass cabinet having a charged display function, including a bypass cabinet body, a cabinet door arranged on an outer wall of the bypass cabinet body, a charged display instrument arranged on an inner wall of the cabinet door, an air inlet opening provided at one end of the charged display instrument, an air outlet opening provided at the other end of the charged display instrument, an abutment portion arranged at an open end of the air outlet opening, and an adjustment portion arranged on a side away from the open end of the air outlet opening, where the charged display instrument is started to enable air to sequentially pass through the air inlet opening and the air outlet opening to enable the charged display instrument to dissipate heat; when a temperature inside the charged display instrument rises, the adjustment portion can approach to a side of the abutment portion, to enable the adjustment portion to abut against the abutment portion and flip.

Further, a diffusion port is provided at the open end of the air outlet opening; the diffusion port is designed in a trapezoidal shape; and when the temperature inside the charged display instrument rises, the adjustment portion is movable from an interior of the air outlet opening to the diffusion port, to enable the charged display instrument to dissipate heat.

Further, the abutment portion includes a straight plate arranged in a mirrored manner on a side inside the diffusion port and a diffusion plate arranged on a side of the straight plate, where when the adjustment portion is driven, the adjustment portion can abut against the diffusion plate, to enable the adjustment portion to rotate.

Further, the adjustment portion includes a telescopic cylinder arranged in a mirrored manner inside the air outlet opening, a collection chamber hingedly connected to a side of the telescopic cylinder, and a compression capsule arranged on a side of the collection chamber, and the compression capsule and the collection chamber communicate with each other, where the compression capsule is adapted to block the air outlet opening, to raise the temperature inside the charged display instrument quickly.

Further, the adjustment portion further includes an air inlet port provided on a side of the collection chamber, an air outlet port provided on the other side of the collection chamber, a down-pressing plate arranged on an inner wall of the compression capsule, and a cleaning plate arranged on an outer wall of the down-pressing plate, where when the telescopic cylinder is driven, the telescopic cylinder can drive the compression capsule to abut against the diffusion plate, to enable the compression capsule to rotate.

Further, the compression capsule is made of a flexible material, and the collection chamber is made of a hard material, where when the compression capsule abuts against the diffusion plate and rotates, the compression capsule is squeezable, to enable the down-pressing plate and the cleaning plate to be squeezed into the collection chamber.

Further, both the air inlet port and the air outlet port extend into the collection chamber, and the air inlet port and the air outlet port abut against an outer wall of the cleaning plate, where when the down-pressing plate and the cleaning plate are squeezed into the collection chamber, the cleaning plate can open the air inlet port and the air outlet port, to enable air inside the charged display instrument to pass through the collection chamber.

Further, an accordion plate is provided on a side of the compression capsule, and a scraper is arranged on an outer wall of the accordion plate, where when the temperature inside the charged display instrument drops, the telescopic cylinder can retract, to enable the scraper to scrape dust on an inner wall of the air outlet opening into the compression capsule.

Further, an outer wall of the charged display instrument is provided with a socket, and the socket is provided at a top end of the diffusion port.

In addition, the present invention further provides a working method of a high-voltage variable-frequency bypass cabinet, including the foregoing high-voltage variable-frequency bypass cabinet having a charged display function, where the charged display instrument is mounted on the cabinet door, and the charged display instrument is connected to an electromagnetic lock, to detect whether the high-voltage variable-frequency bypass cabinet is charged.

When the temperature inside the charged display instrument drops, the telescopic cylinder drives the compression capsule and the collection chamber to retract into the air outlet opening, and the scraper comes into contact with an inner wall of the air outlet opening until the accordion plate is folded, to enable the scraper to scrape dust on the inner wall of the air outlet opening into the compression capsule.

When the temperature inside the charged display instrument rises, the compression capsule blocks the air outlet opening, to enable the temperature inside the charged display instrument to rise quickly.

When the temperature inside the charged display instrument continuously rises, and the compression capsule comes into contact with the diffusion plate, the compression capsule rotates on the telescopic cylinder, for the compression capsule to be squeezed on an inner wall of the diffusion plate; the down-pressing plate and the cleaning plate are squeezed into the collection chamber, the cleaning plate opens the air inlet port and the air outlet port, and drives the compression capsule to discharge dust in the compression capsule into the collection chamber, and hot air discharged from the interior of the charged display instrument can pass through the air inlet port and the air outlet port, to carry the dust in the collection chamber away.

Beneficial effects of the present invention are that: After use of the charged display instrument according to the present invention ends, the adjustment portion can retract to scrape dust on an inner wall of the air outlet opening, and further, the dust is stored in the adjustment portion. Moreover, during use of the charged display instrument, a temperature inside the charged display instrument continuously rises, and the adjustment portion can block the air outlet opening, to enable the charged display instrument to quickly reach an appropriate working temperature.

In addition, when the temperature inside the charged display instrument is excessively high, the adjustment portion is driven, and the adjustment portion can move into the diffusion port, to implement a heat dissipation effect. Moreover, in a process of continuing driving the adjustment portion, the adjustment portion can come into contact with the diffusion plate, to make the adjustment portion inclined. In this case, discharged hot air can quickly pass through an interior of the adjustment portion, and dust inside the adjustment portion can be quickly discharged.

### BRIEF DESCRIPTION OF THE DRAWINGS

The present invention is further described below with reference to the accompanying drawings and embodiments.
FIG. 1 is a three-dimensional view of a preferred embodiment of a high-voltage variable-frequency bypass cabinet having a charged display function according to the present invention;
FIG. 2 is a three-dimensional view of a preferred embodiment of an interior of a high-voltage variable-frequency bypass cabinet having a charged display function according to the present invention;
FIG. 3 is a three-dimensional view of a preferred embodiment of a charged display instrument according to the present invention;
FIG. 4 is a three-dimensional cross-sectional view of a preferred embodiment of an adjustment portion according to the present invention in a first state;
FIG. 5 is a three-dimensional cross-sectional view of a preferred embodiment of an adjustment portion according to the present invention in a second state; and
FIG. 6 is a top cross-sectional view of a preferred embodiment of an adjustment portion according to the present invention.

In the figures:
charged display instrument 1, air inlet opening 11;
diffusion port 2, air outlet opening 21;
socket 3;
abutment portion 4, straight plate 41, diffusion plate 42;
adjustment portion 5, telescopic cylinder 51, compression capsule 52, down-pressing plate 521, cleaning plate 522, accordion plate 53, scraper 531, collection chamber 54, air inlet port 541, air outlet port 542;
bypass cabinet body 6, cabinet door 61.

### DETAILED DESCRIPTION OF THE EMBODIMENTS

The present invention is further described herein in detail with reference to the accompanying drawings. The accompanying drawings are all brief schematic diagrams and are merely used to illustrate basic structures of the present invention, and therefore, only show constitution related to the present invention.

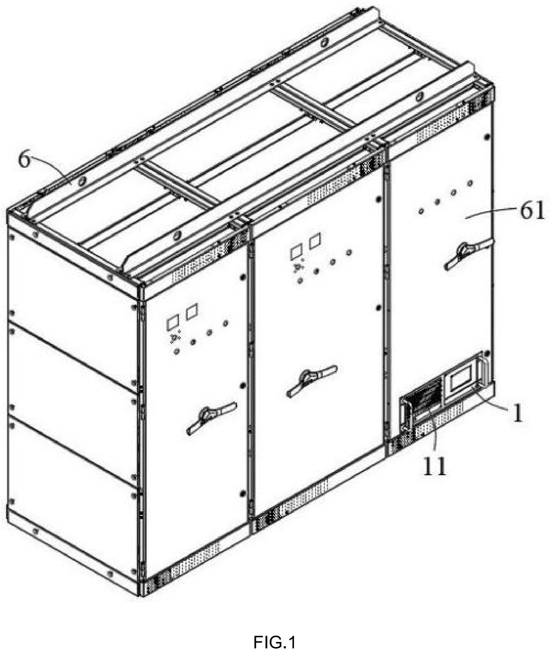

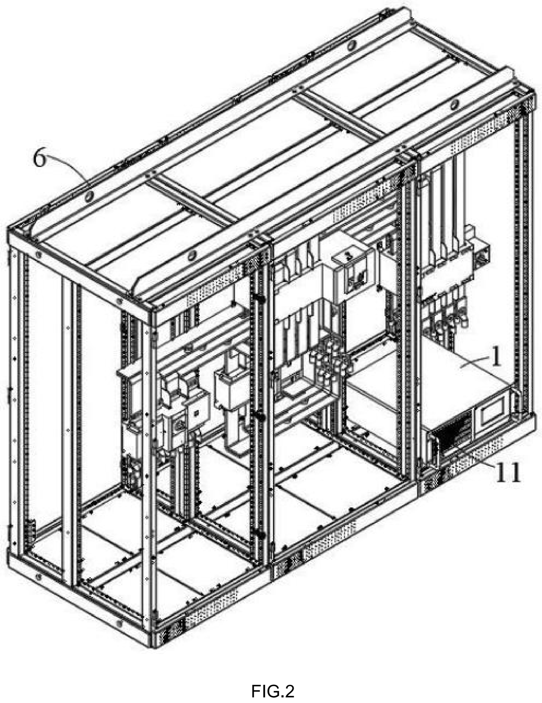

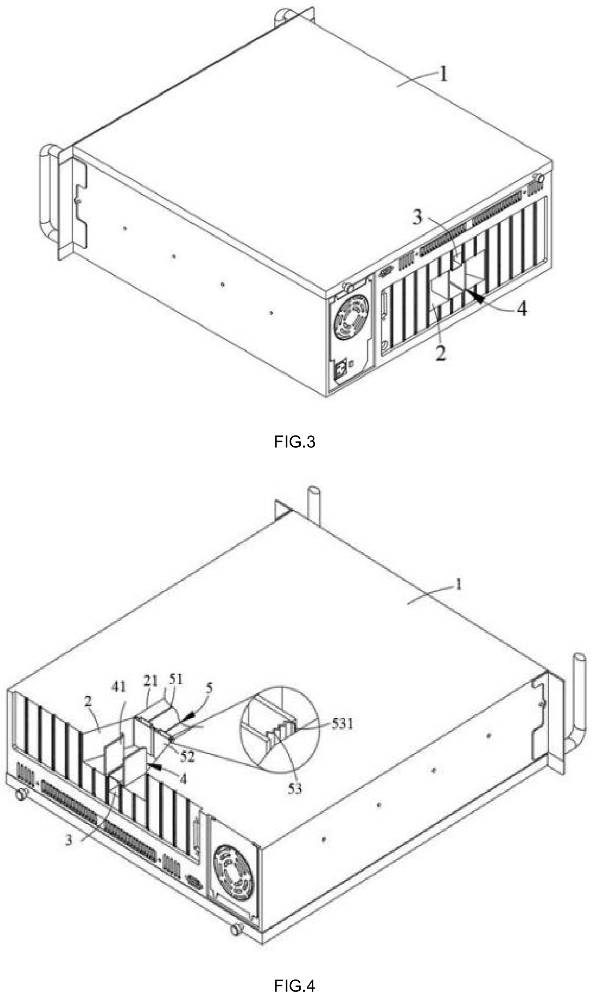

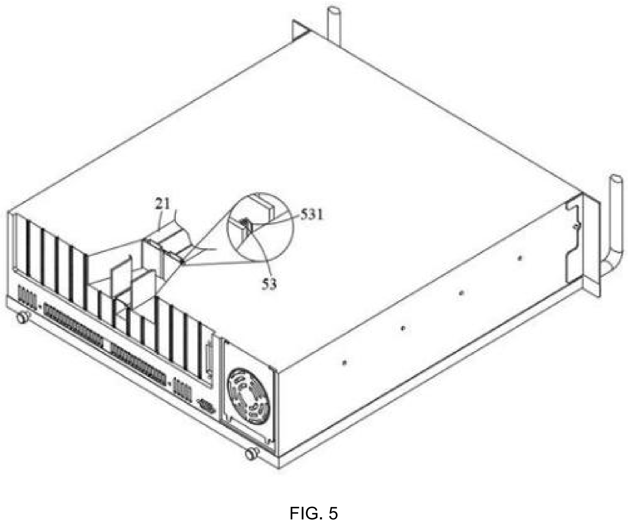

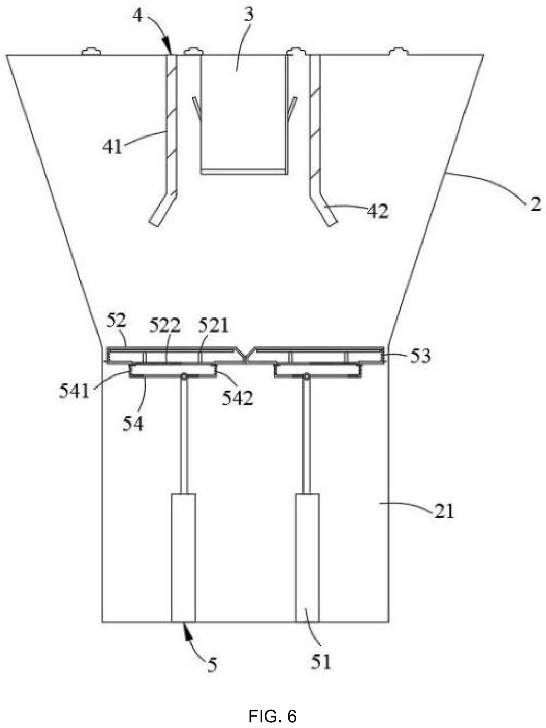

Embodiment 1: As shown in FIG. 1 to FIG. 6, the present invention relates to a high-voltage variable-frequency bypass cabinet having a charged display function according to the present invention is provided, including: a bypass cabinet body 6, a cabinet door 61, a charged display instrument 1, an air inlet opening 11, an air outlet opening 21, an abutment portion 4, and an adjustment portion 5 arranged on a side away from an open end of the air outlet opening 21. After use of the charged display instrument 1 ends, the adjustment portion 5 can retract to scrape dust on an inner wall of the air outlet opening 21, and further, the dust is stored in the adjustment portion 5. Moreover, during use of the charged display instrument 1, a temperature inside the charged display instrument 1 continuously rises, and the adjustment portion 5 can block the air outlet opening 21, to enable the charged display instrument 1 to quickly reach an appropriate working temperature. In addition, when the temperature inside the charged display instrument 1 is excessively high, the adjustment portion 5 is driven, and the adjustment portion 5 can move into a diffusion port 2, to implement a heat dissipation effect. Moreover, in a process of continuing driving the adjustment portion 5, the adjustment portion 5 can come into contact with a diffusion plate 42, to make the adjustment portion 5 inclined. In this case, discharged hot air can quickly pass through an interior of the adjustment portion 5, and dust inside the adjustment portion 5 can be quickly discharged. The foregoing components are described below in detail.

### Bypass cabinet body 6

The bypass cabinet body 6 is formed by a cabinet door 61 and a charged display instrument 1 mounted on the cabinet door 61. During use of the bypass cabinet body 6, the bypass cabinet body 6 and the charged display instrument 1 are connected as one by a wire. The charged display instrument 1 can not only indicate whether a high-voltage circuit is charged, but also cooperate with an electromagnetic lock to achieve forced locking, to prevent a charged chamber from being mistakenly entered, thereby improving anti-error performance of supporting products.

In addition, the charged display instrument 1 is designed as a cuboid, and by providing an air inlet opening 11 and an air outlet opening 21 on side walls of the charged display instrument 1, heat generated by the charged display instrument 1 during working can be quickly dissipated, thereby preventing a high-temperature phenomenon during long-time use of the charged display instrument 1. In addition, providing a socket 3 on the charged display instrument 1 can enable the charged display instrument 1 to be connected by a data cable in use, and can quickly connect the charged display instrument 1 to an appropriate position for detection.

In addition, to facilitate use of the charged display instrument 1, the charged display instrument 1 is further designed for charging and has a battery inside. Such a design enables the charged display instrument 1 to be used in various outdoor environments without being connected to a socket, making the charged display instrument 1 more convenient.

### Diffusion port 2

The diffusion port 2 is also provided on a side wall of the charged display instrument 1 and is in communication with the air outlet opening 21. During use of the charged display instrument 1, outside air is sucked into the charged display instrument 1, and then discharged from the diffusion port 2, which can achieve a cooling effect. In addition, because the diffusion port 2 is designed in a trapezoidal shape, and an enlarged head is directed outward, heat dissipation space can be effectively increased, leading to a better heat dissipation effect.

### Abutment portion 4

The abutment portion 4 is arranged inside the diffusion port 2 and cooperates with the adjustment portion 5. When the adjustment portion 5 is in contact with the abutment portion 4, the abutment portion 4 continuously pushes the adjustment portion 5. In this case, the adjustment portion 5 can flip on the abutment portion 4, and the function of the abutment portion 4 is to squeeze the adjustment portion 5.

A structure of the abutment portion 4 is described below in detail. The abutment portion 4 includes: a straight plate 41 arranged in a mirrored manner on a side inside the diffusion port 2 and the diffusion plate 42 arranged on a side of the straight plate 41. Two straight plates 41 are mounted in a mirrored manner inside the diffusion port 2, and a diffusion plate 42 is mounted on a side wall of the straight plate 41 facing the air outlet opening 21. Such a design is for the adjustment portion 5 to come into contact with the diffusion plate 42 directly when the adjustment portion 5 comes into contact with the straight plate 41. Because the diffusion plate 42 is designed to expand inclinedly outwardly, the diffusion plate 42 can produce a good guiding effect.

It should be noted that because the socket 3 is too long, the socket 3 can be inserted between the two straight plates 41. Through such a design, when the adjustment portion 5 comes into contact with the diffusion plate 42, after flipping, the adjustment portion 5 can be stuck between the socket 3 and the straight plate 41, so that an effect of compressing the adjustment portion 5 can be achieved.

### Adjustment portion 5

The adjustment portion 5 is arranged inside the air outlet opening 21. After use of the charged display instrument 1 ends, the adjustment portion 5 retracts. In a process of retracting, the adjustment portion 5 can scrape dust on the inner wall of the air outlet opening 21, and further, collect the dust inside the adjustment portion 5. Moreover, during use of the charged display instrument 1, a temperature inside the charged display instrument 1 continuously rises, and the adjustment portion 5 can block the air outlet opening 21, to enable the charged display instrument 1 to quickly reach an appropriate working temperature. When heating is needed, the adjustment portion 5 can be pushed toward the diffusion plate 42, to implement a heat dissipation effect.

A structure of the adjustment portion 5 is described below in detail. The adjustment portion 5 includes: a telescopic cylinder 51 arranged in a mirrored manner inside the air outlet opening 21, a collection chamber 54 hingedly connected to a side of the telescopic cylinder 51, and a compression capsule 52 arranged on a side of the collection chamber 54, and the compression capsule 52 and the collection chamber 54 communicate with each other. By mounting the telescopic cylinder 51 inside the air outlet opening 21 and arranging a temperature sensor on the telescopic cylinder 51, when the temperature inside the charged display instrument 1 is low after use of the charged display instrument 1 ends, the temperature sensor on the telescopic cylinder 51 can issue a signal, to cause the telescopic cylinder 51 to retract. Moreover, in a process of retracting of the telescopic cylinder 51, the compression capsule 52 and the collection chamber 54 connected to the telescopic cylinder 51 can also retract together with the telescopic cylinder 51. An accordion plate 53 is provided on a side of the compression capsule 52, and a scraper 531 is arranged on an outer wall of the accordion plate 53. When the compression capsule 52 retracts into the air outlet opening 21, the scraper 531 on the compression capsule 52 can rub against the inner wall of the air outlet opening 21, and further, can drive the accordion plate 53 on the scraper 531 to compress, to open an opening of the compression capsule 52 (that is, the scraper 531 is fixed on and protrudes from an outer wall of the accordion plate 53, and when the compression capsule 52 retracts into the air outlet opening 21, a width between the scrapers 531 on two sides is slightly greater than that of an open inner wall of the air outlet opening 21; further, in a process of retracting of the compression capsule 52, the scraper 531 and the inner wall of the air outlet opening 21 can squeeze each other, and a sliding friction between the scraper 531 and the air outlet opening 21 is greater than a deformation force of the accordion plate 53; further, in a continuous retracting process, the scraper 531 and the inner wall of the air outlet opening 21 slide and rub against each other until the accordion plate 53 compresses, to open the opening of the compression capsule 52). When the accordion plate 53 is compressed to its maximum, the dust scraped by scraper 531 can be guided directly to into the compression capsule 52 for the effect of collection (that is, when the accordion plate 53 is compressed to its maximum, and the compression capsule 52 is opened, the scraper 531 and the inner wall of the air outlet opening 21 continue rubbing against each other, the scraper 531 can scrape dust on the inner wall of the air outlet opening 21, and gradually concentrate the dust on the outer wall of the scraper 531; when the dust on the outer wall of the scraper 531 gradually increases, the dust can gradually enter into the compression capsule 52 along the outer wall of the scraper 531).

In addition, when the telescopic cylinder 51 pushes the compression capsule 52 to move to come into contact with the diffusion plate 42 in the diffusion port 2 and be inclined, the heat dissipation effect is the best. Further, a torsion spring connected between the telescopic cylinder 51 and the compression capsule 52 is stressed and deformed. Moreover, when the telescopic cylinder 51 retracts, the compression capsule 52 is gradually detached from the diffusion plate 42, the torsion spring at a junction between the telescopic cylinder 51 and the compression capsule 52 is gradually released, and then, rotates to return until the telescopic cylinder 51 completely retracts. After the compression capsule 52 is not in contact with the diffusion plate 42 at all, the torsion spring can return to an initial position.

Because widths of two compression capsule 52 and a width of the air outlet opening 21 are adapted to each other, after use of the charged display instrument 1 ends, when the telescopic cylinder 51 retracts, the compression capsules 52 can block the air outlet opening 21, to prevent foreign matter from entering the air outlet opening 21.

It should be noted that the width of the compression capsule 52 is greater than the width of the collection chamber 54. When the compression capsule 52 rubs against the inner wall of the air outlet opening 21, the air outlet opening 21 is not in contact with the outer wall of the collection chamber 54.

The adjustment portion 5 further includes an air inlet port 541 provided on one side of the collection chamber 54, an air outlet port 542 provided on the other side of the collection chamber 54, a down-pressing plate 521 arranged on an inner wall of the compression capsule 52, and a cleaning plate 522 arranged on an outer wall of the down-pressing plate 521. During use of the charged display instrument 1, some heat is generated inside the charged display instrument 1, to ensure use of the charged display instrument 1 in an environment with a low outside temperature. The compression capsule 52 first blocks the opening of the air outlet opening 21, and in this case, the heat generated by the charged display instrument 1 can quickly raise the temperature of the battery inside the charged display instrument 1, to enable the battery to quickly reach an appropriate working temperature, thereby preventing an excessively low temperature from affecting a battery life while improving a service life of the battery.

Moreover, when use of the charged display instrument 1 is continued, the internal temperature continuously rises, and in this case, a temperature sensor on the telescopic cylinder 51 can start, and the telescopic cylinder 51 moves toward the diffusion plate 42. Because the diffusion port 2 is designed in a trapezoidal shape, hot air can flow through a gap between the diffusion port 2 and the compression capsule 52, to dissipate heat.

It should be noted that when the telescopic cylinder 51 pushes the compression capsule 52 to move to come into contact with the diffusion port 2 and be inclined, the heat dissipation effect is the best. Because the compression capsule 52 is made of a flexible material, and the collection chamber 54 is made of a hard material, the compression capsule 52 and the collection chamber 54 can rotate on the telescopic cylinder 51, and the compression capsule 52 is squeezed, and is stuck between the socket 3 and the straight plate 41. After the compression capsule 52 is squeezed, the cleaning plate 522 and the down-pressing plate 521 inside the compression capsule 52 can also be squeezed into the collection chamber 54, so that dust inside the compression capsule 52 is brought into the collection chamber 54. In addition, because the compression capsule 52 can only be squeezed toward the collection chamber 54. Such a deformation manner does not affect a force that the compression capsule 52 is subjected when scrabbing the dust on the air outlet opening 21.

In addition, both the air inlet port 541 and the air outlet port 542 extend into the collection chamber 54, and the air inlet port 541 and the air outlet port 542 abut against an outer wall of the cleaning plate 522. Further, when the cleaning plate 522 moves toward an interior of the collection chamber 54, the cleaning plate 522 can open the air inlet port 541 and the air outlet port 542. Because in this case, the collection chamber 54 is parallel to a direction of the air outlet opening 21, when hot air is blown from the air outlet opening 21, the hot air can enter the collection chamber 54 from the air inlet port 541, and carry dust in the collection chamber 54 away from the air outlet port 542, to implement a self-cleaning effect, thereby preventing the inner wall of the air outlet opening 21 from being attached to by dust for a long term and affecting the heat dissipation effect of the charged display instrument 1.

Embodiment 2: Based on Embodiment 1, Embodiment 2 further provides a working method of a high-voltage variable-frequency bypass cabinet, including the high-voltage variable-frequency bypass cabinet having a charged display function according to Embodiment 1, and a specific structure is the same as that in Embodiment 1. Details are not described herein again. Specifically, a working method of a high-voltage variable-frequency bypass cabinet is as follows:

The charged display instrument 1 is mounted on the cabinet door 61, and the charged display instrument 1 is connected to an electromagnetic lock, to detect whether the high-voltage variable-frequency bypass cabinet is charged.

When the temperature inside the charged display instrument 1 drops, the telescopic cylinder 51 drives the compression capsule 52 and the collection chamber 54 to retract into the air outlet opening 21, and the scraper 531 comes into contact with an inner wall of the air outlet opening 21 until the accordion plate 53 is folded, to enable the scraper 531 to scrape dust on the inner wall of the air outlet opening 21 into the compression capsule 52.

When the temperature inside the charged display instrument 1 rises, the compression capsule 52 blocks the air outlet opening 21, to enable the temperature inside the charged display instrument 1 to rise quickly.

When the temperature inside the charged display instrument 1 continuously rises, and the compression capsule 52 comes into contact with the diffusion plate 42, the compression capsule 52 rotates on the telescopic cylinder 51, for the compression capsule 52 to be squeezed on an inner wall of the diffusion plate 42; the down-pressing plate 521 and the cleaning plate 522 are squeezed into the collection chamber 54, the cleaning plate 522 opens the air inlet port 541 and the air outlet port 42, and drives the compression capsule 52 to discharge dust in the compression capsule 52 into the collection chamber 54, and hot air discharged from the interior of the charged display instrument 1 can pass through the air inlet port 541 and the air outlet port 542, to carry the dust in the collection chamber 54 away.

Under the light of the ideal embodiments of the present invention, through the foregoing descriptions, a person skilled in the art may make various changes and modifications without departing from the scope of the technical idea of the present invention. The technical scope of the present invention is not limited to the content of the description, and the technical scope thereof should be determined according to the scope of the claims.

## Claims

1. A high-voltage variable-frequency bypass cabinet having a charged display function, **characterized in that**, the cabinet comprising:
a bypass cabinet body (6), a cabinet door (61) arranged on an outer wall of the bypass cabinet body (6), a charged display instrument (1) arranged on an inner wall of the cabinet door (61), an air inlet opening (11) provided at one end of the charged display instrument (1), an air outlet opening (21) provided at the other end of the charged display instrument (1), an abutment portion (4) arranged at an open end of the air outlet opening (21), and an adjustment portion (5) arranged on a side away from the open end of the air outlet opening (21), wherein
the charged display instrument (1) is started to enable air to sequentially pass through the air inlet opening (11) and the air outlet opening (21), to enable the charged display instrument (1) to dissipate heat;
when a temperature inside the charged display instrument (1) rises, the adjustment portion (5) approaches to a side of the abutment portion (4), to enable the adjustment portion (5) to abut against the abutment portion (4) and flip; and
the adjustment portion (5) comprises a telescopic cylinder (51) arranged in a mirrored manner inside the air outlet opening (21), a collection chamber (54) hingedly connected to a side of the telescopic cylinder (51), and a compression capsule (52) arranged on a side of the collection chamber (54), and the compression capsule (52) and the collection chamber (54) communicate with each other, wherein
the compression capsule (52) is adapted to block the air outlet opening (21), to raise the temperature inside the charged display instrument (1) quickly;
the adjustment portion (5) further comprises an air inlet port (541) provided on a side of the collection chamber (54), an air outlet port (542) provided on the other side of the collection chamber (54), a down-pressing plate (521) arranged on an inner wall of the compression capsule (52), and a cleaning plate (522) arranged on an outer wall of the down-pressing plate (521), wherein
when the telescopic cylinder (51) is driven, the telescopic cylinder (51) drives the compression capsule (52) to abut against a diffusion plate (42), to enable the compression capsule (52) to rotate;
the compression capsule (52) is made of a flexible material, and the collection chamber (54) is made of a hard material, wherein
when the compression capsule (52) abuts against the diffusion plate (42) and rotates, the compression capsule (52) is squeezable, to enable the down-pressing plate (521) and the cleaning plate (522) to be squeezed into the collection chamber (54);
both the air inlet port (541) and the air outlet port (542) extend into the collection chamber (54), and the air inlet port (541) and the air outlet port (542) abut against an outer wall of the cleaning plate (522), wherein
when the down-pressing plate (521) and the cleaning plate (522) are squeezed into the collection chamber (54), the cleaning plate (522) is capable of opening the air inlet port (541) and the air outlet port (542), to enable air inside the charged display instrument (1) to pass through the collection chamber (54);
an accordion plate (53) is provided on a side of the compression capsule (52), and a scraper (531) is arranged on an outer wall of the accordion plate (53), wherein
when the temperature inside the charged display instrument (1) drops, the telescopic cylinder (51) is retractable, to enable the scraper (531) to scrape dust on an inner wall of the air outlet opening (21) into the compression capsule (52).

2. The high-voltage variable-frequency bypass cabinet having the charged display function according to claim 1, **characterized in that**
a diffusion port (2) is provided at the open end of the air outlet opening (21);
the diffusion port (2) is designed in a trapezoidal shape; and
when the temperature inside the charged display instrument (1) rises, the adjustment portion (5) is movable from an interior of the air outlet opening (21) to the diffusion port (2), to enable the charged display instrument (1) to dissipate heat.

3. The high-voltage variable-frequency bypass cabinet having the charged display function according to claim 2, **characterized in that** t
he abutment portion (4) comprises a straight plate (41) arranged in a mirrored manner on a side inside the diffusion port (2) and the diffusion plate (42) arranged on a side of the straight plate (41), wherein when the adjustment portion (5) is driven, the adjustment portion (5) abuts against the diffusion plate (42), to enable the adjustment portion (5) to rotate.

4. The high-voltage variable-frequency bypass cabinet having the charged display function according to claim 3, **characterized in that**
an outer wall of the charged display instrument (1) is provided with a socket (3), and the socket (3) is provided at a top end of the diffusion port (2).

5. A working method of a high-voltage variable-frequency bypass cabinet, comprising the high-voltage variable-frequency bypass cabinet having the charged display function according to claim 4, **characterized in that**
the charged display instrument (1) is mounted on the cabinet door (61), and the charged display instrument (1) is connected to an electromagnetic lock, to detect whether the high-voltage variable-frequency bypass cabinet is charged; when the temperature inside the charged display instrument (1) drops, the telescopic cylinder (51) drives the compression capsule (52) and the collection chamber (54) to retract into the air outlet opening (21), and the scraper (531) comes into contact with an inner wall of the air outlet opening (21) until the accordion plate (53) is folded, to enable the scraper (531) to scrape dust on the inner wall of the air outlet opening (21) into the compression capsule (52);
when the temperature inside the charged display instrument (1) rises, the compression capsule (52) blocks the air outlet opening (21), to enable the temperature inside the charged display instrument (1) to rise quickly; when the temperature inside the charged display instrument (1) continuously rises, and the compression capsule (52) comes into contact with the diffusion plate (42), the compression capsule (52) rotates on the telescopic cylinder (51), for the compression capsule (52) to be squeezed on an inner wall of the diffusion plate (42); the down-pressing plate (521) and the cleaning plate (522) are squeezed into the collection chamber (54), the cleaning plate (522) opens the air inlet port (541) and the air outlet port (542), and drives the compression capsule (52) to discharge dust in the compression capsule (52) into the collection chamber (54), and hot air discharged from the interior of the charged display instrument (1) passes through the air inlet port (541) and the air outlet port (542), to carry the dust in the collection chamber (54) away.
